# EUROPÄISCHE PATENTANMELDUNG

(11) **EP 3 940 106 A1**
(43) Veröffentlichungstag der Anmeldung: **19.01.2022**
(21) Anmeldenummer: 20185920.4
(22) Anmeldetag: 15.07.2020
(51) Int. Cl.: C23C 4/08, B21C 37/09, B21C 37/12, C23C 4/134, C23C 4/14, C23C 4/16, C23C 14/16, C23C 28/02, C23C 2/06, C23C 2/12, C23C 2/38, C23C 28/00

(54) **VERFAHREN ZUM BESCHICHTEN EINER ROHRLEITUNG UND ROHRLEITUNG**

(71) Anmelder: TI Automotive Engineering Centre (Heidelberg) GmbH, 69123 Heidelberg (DE)
(72) Erfinder: Sinn, Christian, 68526 Ladenburg (DE); Tschachtschal , Alexander, 69123 Heidelberg (DE)
(74) Vertreter: Andrejewski - Honke Patent- und Rechtsanwälte Partnerschaft mbB

(57) **Zusammenfassung**

Verfahren zum Beschichten einer Rohrleitung, insbesondere einer Kraftfahrzeug-Rohrleitung, wobei ein metallisches Innenrohr eingesetzt wird und wobei die Außenoberfläche des metallischen Innenrohres mit zumindest einer Metallschicht versehen wird. Im Anschluss daran wird eine Haftvermittlerschicht auf die Metallschicht aufgebracht. Daraufhin wird die Rohrleitung mit zumindest einer äußeren Schicht versehen. Die Haftvermittlerschicht wird durch Plasmabeschichtung aufgebracht.

## Beschreibung

Die Erfindung betrifft ein Verfahren zum Beschichten einer Rohrleitung, insbesondere einer Kraftfahrzeug-Rohrleitung, vorzugsweise für Kraftstoffe und/oder Hydraulikflüssigkeiten, wobei ein metallisches Innenrohr eingesetzt wird, wobei die Außenoberfläche des metallischen Innenrohres mit zumindest einer Metallschicht versehen wird, wobei im Anschluss daran zumindest eine Haftvermittlerschicht auf die Metallschicht aufgebracht wird und wobei daraufhin die Rohrleitung mit zumindest einer äußeren Schicht versehen wird. Die Erfindung betrifft weiterhin eine entsprechende Rohrleitung, vorzugsweise für Kraftstoffe und/oder Hydraulikflüssigkeiten.

Verfahren der vorstehend beschriebenen Art sind aus der Praxis in unterschiedlichen Ausführungsformen bekannt. Dabei erfolgt die Aufbringung der Haftvermittlerschicht in der Regel im Rahmen von nasschemischen Verfahren. Der Haftvermittler wird dabei in einem Lösungsmittel gelöst eingesetzt. Insoweit sind die bekannten Maßnahmen im Hinblick auf Umweltaspekte und Gesundheitsaspekte der Kritik offen. Die bekannten Verfahren machen aufwendige Vorbehandlungsmaßnahmen und Reinigungsmaßnahmen der zu beschichtenden Oberflächen erforderlich. Im Rahmen der nasschemischen Verfahren zur Haftvermittleraufbringung müssen relativ komplexe Parametereinstellungen eingehalten werden und zwar insbesondere im Hinblick auf die Temperatur, den pH-Wert und das Mischungsverhältnis der Komponenten. Insgesamt sind die bekannten Maßnahmen verhältnismäßig aufwendig und somit auch kostspielig. Insoweit besteht Verbesserungsbedarf.

Der Erfindung liegt das technische Problem zugrunde, ein Verfahren der eingangs beschriebenen Art anzugeben, bei dem die vorstehend erwähnten Nachteile effektiv vermieden werden können. Außerdem liegt der Erfindung das technische Problem zugrunde, eine entsprechende Rohrleitung anzugeben.

Zur Lösung des technischen Problems lehrt die Erfindung ein Verfahren zum Beschichten einer Rohrleitung, insbesondere einer Kraftfahrzeug-Rohrleitung, vorzugsweise für Kraftstoffe und/oder Hydraulikflüssigkeiten, wobei ein metallisches Innenrohr eingesetzt wird, wobei die Außenoberfläche des metallischen Innenrohres mit zumindest einer Metallschicht versehen wird, wobei im Anschluss daran zumindest eine Haftvermittlerschicht auf die Metallschicht aufgebracht wird und wobei daraufhin die Rohrleitung mit zumindest einer äußeren Schicht versehen wird und wobei zumindest die Haftvermittlerschicht durch Plasmabeschichtung aufgebracht wird.

Der Erfindung liegt die Erkenntnis zugrunde, dass die Aufbringung der Haftvermittlerschicht durch Plasmabeschichtung zum einen relativ einfach und wenig aufwendig durchführbar ist. Es entfallen die aus dem Stand der Technik bzw. aus der Praxis bekannten aufwendigen Parametereinstellungen. Auch im Hinblick auf Umweltaspekte und Gesundheitsaspekte zeichnet sich das erfindungsgemäße Verfahren gegenüber den bislang bekannten Maßnahmen durch Vorteile aus. Die Haftvermittlerschichten können sehr homogen aufgebracht werden und Fehlstellen werden dabei quasi ausgeschlossen. Die Haftvermittlerschicht kann mit einer konstanten niedrigen Schichtdicke reproduzierbar aufgebracht werden. Das erfindungsgemäße Verfahren bzw. die erfindungsgemäße Beschichtung zeichnet sich weiterhin auch durch relativ geringe Kosten aus.

Erfindungsgemäß wird auf die Außenoberfläche des metallischen Innenrohres zumindest eine Metallschicht aufgebracht. Gemäß besonders empfohlener Ausführungsform der Erfindung enthält die Metallschicht zumindest ein Metall aus der Gruppe "Aluminium, Zink, Aluminium-Legierung, Zink-Legierung". Als Zink-Legierung wird dabei insbesondere sogenanntes Galfan eingesetzt, wobei es sich um eine Zink-Aluminium-Legierung handelt, die zum größten Teil bzw. zu über 90 Gew.-% aus Zink besteht sowie aus Aluminium und geringen Anteilen Seltenerdenmetall und/oder Edelmetall. Aluminium ist zu etwa 3 bis 7 Gew.-%, bevorzugt zu 4 bis 6 Gew.-% und insbesondere zu 5 Gew.-% in der Legierung vorhanden. Zink ist vorzugsweise zu mehr als 92 Gew.-% in der Legierung vorhanden.

Gemäß einer empfohlenen Ausführungsform des erfindungsgemäßen Verfahrens wird die Metallschicht durch eine Hot-Dip-Beschichtung auf dem metallischen Innenrohr aufgebracht. Dabei kann das metallische Innenrohr durch das schmelzflüssige Metall für die Metallschicht geführt werden, so dass das metallische Innenrohr von außen mit dem Metall benetzt wird. Vorzugsweise wird die Metallschicht mit einer Schichtdicke von 50 bis 200 µm auf das Innenrohr aufgebracht.

Erfindungsgemäß wird die Haftvermittlerschicht durch Plasmabeschichtung auf das mit der Metallschicht beschichtete metallische Innenrohr aufgebracht. Zweckmäßigerweise erfolgt dieses Aufbringen der Haftvermittlerschicht mit einer Schichtdicke von 10 nm bis 10 µm, bevorzugt 10 nm bis 1 µm und insbesondere von 10 bis 700 nm. Es hat sich bewährt, dass die Plasmabeschichtung mit dem Haftvermittler bei Normaldruck bzw. bei Atmosphärendruck durchgeführt wird. Es liegt im Rahmen der Erfindung, dass die Plasmabeschichtung als physikalische Gasphasenabscheidung und/oder als chemische Gasphasenabscheidung durchgeführt wird.

Zweckmäßigerweise wird für die Plasmabeschichtung eine Plasmabeschichtungs-Vorrichtung eingesetzt und das Material für die Haftvermittlerschicht wird der Plasmabeschichtungs-Vorrichtung pulverförmig zugeführt. Es liegt im Rahmen der Erfindung, dass das Material für die Haftvermittlerschicht in der Plasmabeschichtungs-Vorrichtung in die Gasphase überführt und anschließend in fester Form auf der Rohrleitung abgeschieden wird.

Erfindungsgemäß wird auf der Haftvermittlerschicht bzw. über der Haftvermittlerschicht eine äußere Schicht aufgebracht. Nach bevorzugter Ausführungsform der Erfindung besteht diese äußere Schicht aus zumindest einem Polymer bzw. im Wesentlichen aus zumindest einem Polymer. Bei dem Polymer handelt es sich vorzugsweise um zumindest ein Polyamid und/oder um zumindest ein Polyolefin. Nach einer Ausgestaltung besteht die äußere Schicht aus einem Polyamid bzw. im Wesentlichen aus einem Polyamid und nach einer anderen Ausgestaltung der Erfindung besteht die äußere Schicht aus einem Polyolefin bzw. im Wesentlichen aus einem Polyolefin.

Eine empfohlene Ausführungsform der Erfindung ist dadurch gekennzeichnet, dass der Metallschicht und der Haftvermittlerschicht eine chromfreie Zwischenschicht zwischengeschaltet ist. Es hat sich bewährt, dass die chromfreie Zwischenschicht zumindest ein Phosphatierungsmittel aufweist und nach einer Ausführungsform aus zumindest einem Phosphatierungsmittel besteht bzw. im Wesentlichen besteht. Gemäß einer Ausgestaltung der Erfindung ist die chromfreie Zwischenschicht als Dichtungsschicht ausgebildet und diese Schicht weist vorzugsweise zumindest ein Polymer auf. Bei dem Polymer handelt es sich insbesondere um ein Polyvinyl-Polymer. - Eine bevorzugte Ausführungsform zeichnet sich dadurch aus, dass die chromfreie Zwischenschicht bzw. die Dichtungsschicht mit einer Dicke von 0,2 bis 1 µm aufgebracht wird.

Es liegt im Rahmen der Erfindung, dass auf die chromfreie Zwischenschicht die äußere Schicht aufgebracht wird, die bevorzugt aus zumindest einem Polymer besteht. Nach sehr empfohlener Ausführungsform der Erfindung wird die äußere Schicht mit einer Schichtdicke von 0,2 bis 3 mm und insbesondere von 1 bis 3 mm aufgebracht.

Zur Lösung des technischen Problems lehrt die Erfindung weiterhin eine Rohrleitung, insbesondere eine Kraftfahrzeug-Rohrleitung, vorzugsweise für Kraftstoffe und/oder Hydraulikflüssigkeiten, wobei die Rohrleitung ein metallisches Innenrohr aufweist, wobei auf dem metallischen Innenrohr eine Metallschicht vorgesehen ist und wobei auf der Metallschicht eine Haftvermittlerschicht vorhanden ist und wobei die Rohrleitung zusätzlich eine äußere Schicht aufweist und wobei die Haftvermittlerschicht als Plasmabeschichtung aufgebracht ist.

Bei dem metallischen Innenrohr handelt es sich gemäß einer Ausführungsform um ein mehrwandiges Rohr, insbesondere um ein doppelwandiges Rohr. Es liegt dabei im Rahmen der Erfindung, dass zur Erzeugung des mehrwandigen bzw. doppelwandigen Rohres ein Metallband, insbesondere ein Stahlband zu dem Rohr aufgerollt wird.

Der Erfindung liegt die Erkenntnis zugrunde, dass die Aufbringung der Haftvermittlerschicht zwischen der Metallschicht und der äußeren Schicht ganz besondere Vorteile mit sich bringt. Zum einen ist diese Plasmabeschichtung sehr einfach und wenig aufwendig durchführbar. Auf die aufwendigen Maßnahmen bei den aus der Praxis bekannten nasschemischen Verfahren kann bei der Erfindung vollständig verzichtet werden. Insoweit können auch die umwelttechnischen und gesundheitlichen Probleme vermieden werden, die mit den bekannten Maßnahmen einhergehen. Komplexe Parametereinstellungen entfallen bei der Erfindung vollständig. Die mit der Plasmabeschichtung aufgebrachte Haftvermittlerschicht kann reproduzierbar homogen und mit einer konstanten Schichtdicke aufgebracht werden. Diese Maßnahmen sind relativ kostengünstig und nichtsdestoweniger effektiv und präzise durchführbar.

Nachfolgend wird die Erfindung anhand einer lediglich ein Ausführungsbeispiel darstellenden Zeichnung näher erläutert. Es zeigen in schematischer Darstellung:

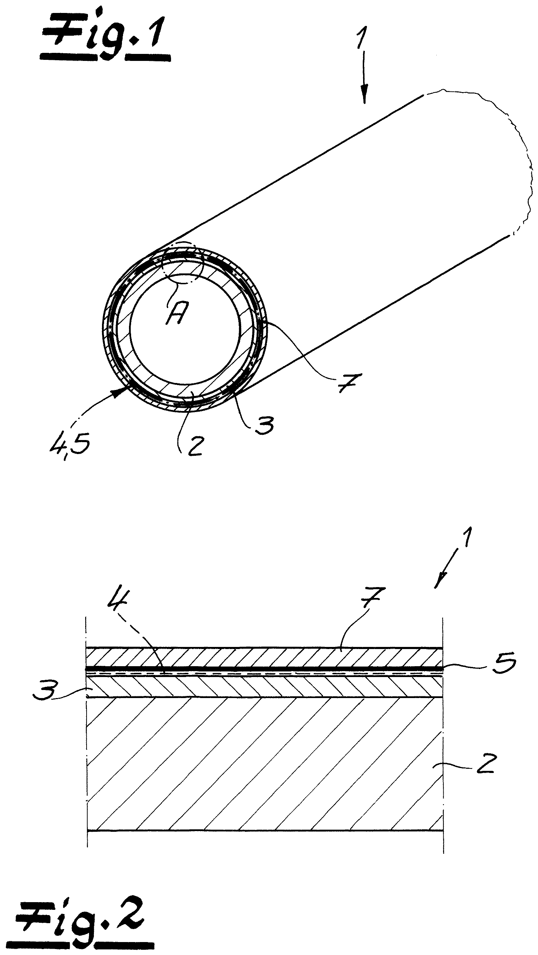

- Fig. 1: eine perspektivische Darstellung einer nach dem erfindungsgemäßen Verfahren beschichteten Rohrleitung,
- Fig. 2: einen vergrößerten Ausschnitt A aus der Fig. 1 und
- Fig. 3: eine schematische Darstellung einer bevorzugten Ausführungsform einer für das erfindungsgemäße Verfahren geeigneten Plasmabeschichtungs-Vorrichtung.

Die Figuren zeigen eine Rohrleitung 1, die nach dem erfindungsgemäßen Verfahren beschichtet wurde. Vorzugsweise und im Ausführungsbeispiel mag es sich um eine Kraftfahrzeug-Rohrleitung handeln, die bevorzugt für Kraftstoffe und/oder Hydraulikflüssigkeiten eingesetzt wird. Die Rohrleitung 1 weist ein metallisches Innenrohr 2 auf, das bevorzugt und im Ausführungsbeispiel als Stahlrohr ausgeführt ist. Dieses metallische Innenrohr 2 ist mit einer Metallschicht 3 versehen, die vorzugsweise und im Ausführungsbeispiel als Aluminiumschicht ausgebildet ist. Die Aluminiumschicht mag durch ein Hot-Dip-Verfahren auf das metallische Innenrohr 2 aufgebracht worden sein. Statt einer Aluminiumschicht kann insbesondere auch eine Metallschicht 3 aus Galfan auf das metallische Innenrohr 2 aufgebracht werden.

Nach bevorzugter Ausführungsform und im Ausführungsbeispiel ist auf die Metallschicht 3 bzw. die Aluminiumschicht eine chromfreie Zwischenschicht 4 aufgebracht, die nach einer Ausführungsform ein Phosphatierungsmittel aufweisen mag. - Die Schichtdicke der Metallschicht 3 mag im Ausführungsbeispiel 50 bis 150 µm betragen und die Schichtdicke der chromfreien Zwischenschicht 4 mag im Ausführungsbeispiel 0,2 bis 1 µm betragen.

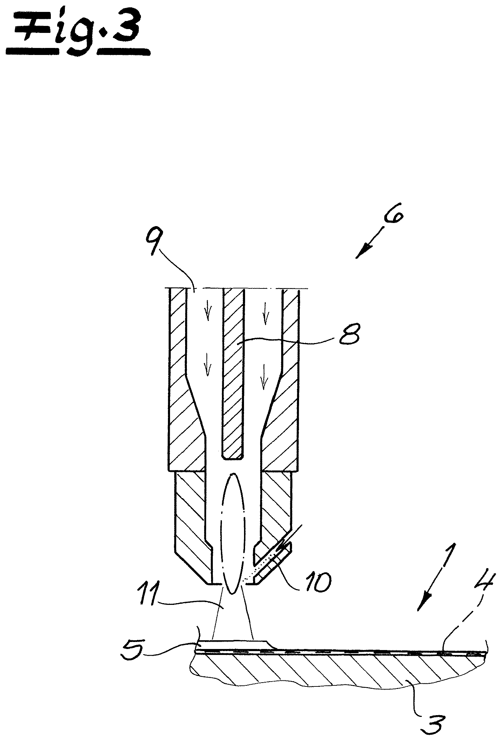

Auf die chromfreie Zwischenschicht 4 ist eine Haftvermittlerschicht 5 aufgebracht. Erfindungsgemäß wird diese Haftvermittlerschicht 5 durch Plasmabeschichtung aufgebracht und zwar bevorzugt mit einer in der Fig. 3 dargestellten Plasmabeschichtungs-Vorrichtung 6. Die Dicke der Haftvermittlerschicht 5 mag zweckmäßigerweise und im Ausführungsbeispiel 2 bis 8 µm betragen. - Nach der Aufbringung der Haftvermittlerschicht 5 auf die Rohrleitung 1 wird vorzugsweise eine äußere Schicht 7 aufgebracht, die bevorzugt und im Ausführungsbeispiel aus Polyamid bzw. im Wesentlichen aus Polyamid besteht. Die Schichtdicke der äußeren Schicht 7 mag im Ausführungsbeispiel 1 bis 2 mm betragen.

In Fig. 3 ist eine bevorzugte Ausführungsform einer Plasmabeschichtungs-Vorrichtung 6 dargestellt, mit der bevorzugt die Haftvermittlerschicht 5 durch Plasmabeschichtung auf die Rohrleitung 1 aufgebracht wird. Zu erkennen ist die Elektrode 8 der Plasmabeschichtungs-Vorrichtung 6 sowie die Gaszuführung 9. Die Plasmabeschichtungs-Vorrichtung 6 weist einen Kanal 10 auf, durch den das Material für die Haftvermittlerschicht 5 pulverförmig eingebracht werden kann. Das Material wird dann mit der Vorrichtung 6 in die Gasphase überführt und schließlich fest auf der Rohrleitung 1 als Haftvermittlerschicht 5 aufgebracht. Zu erkennen ist in der Fig. 3 auch der Plasmastrahl 11 der Plasmabeschichtungs-Vorrichtung 6.

## Patentansprüche

1. Verfahren zum Beschichten einer Rohrleitung (1), insbesondere einer Kraftfahrzeug-Rohrleitung, vorzugsweise für Kraftstoffe und/oder Hydraulikflüssigkeiten, wobei ein metallisches Innenrohr (2) eingesetzt wird, wobei die Außenoberfläche des metallischen Innenrohres (2) mit zumindest einer Metallschicht (3) versehen wird, wobei im Anschluss daran zumindest eine Haftvermittlerschicht (5) auf die Metallschicht (3) aufgebracht wird und wobei daraufhin die Rohrleitung (1) mit zumindest einer äußeren Schicht (7) versehen wird, **dadurch gekennzeichnet, dass** zumindest die Haftvermittlerschicht (5) durch Plasmabeschichtung aufgebracht wird.

2. Verfahren nach Anspruch 1, **dadurch gekennzeichnet, dass** die Metallschicht (3) zumindest ein Metall aus der Gruppe "Aluminium, Zink, Aluminium-Legierung, Zink-Legierung" enthält.

3. Verfahren nach einem der Ansprüche 1 oder 2, **dadurch gekennzeichnet, dass** die Metallschicht (3) durch Hot-Dip-Beschichtung auf das Innenrohr (2) aufgebracht wird.

4. Verfahren nach einem der Ansprüche 1 bis 3, **dadurch gekennzeichnet, dass** die Metallschicht (3) mit einer Schichtdicke von 50 bis 200 µm auf das Innenrohr (2) aufgebracht wird.

5. Verfahren nach einem der Ansprüche 1 bis 4, **dadurch gekennzeichnet, dass** die Haftvermittlerschicht (5) mit einer Schichtdicke von 10 nm bis 10 µm, insbesondere von 10 bis 700 nm aufgebracht wird.

6. Verfahren nach einem der Ansprüche 1 bis 5, **dadurch gekennzeichnet, dass** die Plasmabeschichtung mit dem Haftvermittler bei Normaldruck bzw. bei Atmosphärendruck durchgeführt wird.

7. Verfahren nach einem der Ansprüche 1 bis 6, **dadurch gekennzeichnet, dass** die Plasmabeschichtung als physikalische Gasphasenabscheidung und/oder als chemische Gasphasenabscheidung durchgeführt wird.

8. Verfahren nach einem der Ansprüche 1 bis 7, **dadurch gekennzeichnet, dass** für die Plasmabeschichtung eine Plasmabeschichtungs-Vorrichtung (6) eingesetzt wird und dass das Material für die Haftvermittlerschicht (5) der Plasmabeschichtungs-Vorrichtung (6) pulverförmig zugeführt wird.

9. Verfahren nach einem der Ansprüche 1 bis 8, **dadurch gekennzeichnet, dass** das Material für die Haftvermittlerschicht (5) in der Plasmabeschichtungs-Vorrichtung (6) in die Gasphase überführt wird und anschließend in fester Form auf der Rohrleitung (1) abgeschieden wird.

10. Verfahren nach einem der Ansprüche 1 bis 9, **dadurch gekennzeichnet, dass** als äußere Schicht (7) eine Schicht aus zumindest einem Polymer, insbesondere aus zumindest einem Polyamid und/oder aus zumindest einem Polyolefin eingesetzt wird.

11. Verfahren nach einem der Ansprüche 1 bis 10, **dadurch gekennzeichnet, dass** der Metallschicht (3) und der Haftvermittlerschicht (5) eine chromfreie Zwischenschicht (4) zwischengeschaltet wird.

12. Verfahren nach einem der Ansprüche 1 bis 11, **dadurch gekennzeichnet, dass** die chromfreie Zwischenschicht (4) zumindest ein Phosphatierungsmittel aufweist, insbesondere aus zumindest einem Phosphatierungsmittel besteht bzw. im Wesentlichen besteht.

13. Verfahren nach einem der Ansprüche 1 bis 12, **dadurch gekennzeichnet, dass** die chromfreie Zwischenschicht (4) mit einer Dicke von 0,2 bis 1 µm aufgebracht wird.

14. Verfahren nach einem der Ansprüche 1 bis 13, **dadurch gekennzeichnet, dass** die äußere Schicht (7) mit einer Schichtdicke von 0,2 bis 3 mm aufgebracht wird.

15. Rohrleitung, insbesondere Kraftfahrzeug-Rohrleitung, vorzugsweise für Kraftstoffe und/oder Hydraulikflüssigkeiten, insbesondere beschichtet nach einem der Ansprüche 1 bis 14, wobei die Rohrleitung (1) ein metallisches Innenrohr (2) aufweist, wobei auf dem metallischen Innenrohr (2) eine Metallschicht (3) vorgesehen ist und wobei auf der Metallschicht (3) eine Haftvermittlerschicht (5) vorhanden ist und wobei die Rohrleitung (1) zusätzlich eine äußere Schicht (7) aufweist, **dadurch gekennzeichnet, dass** die Haftvermittlerschicht (5) als Plasmabeschichtung aufgebracht ist.
